# EUROPÄISCHE PATENTSCHRIFT

(11) **EP 3 802 059 B1**
(45) Veröffentlichungstag und Bekanntmachung des Hinweises auf die Patenterteilung: **22.11.2023**
(21) Anmeldenummer: 19726969.9
(22) Anmeldetag: 24.05.2019
(51) Int. Cl.: B29C 59/02, B29C 37/00, B29C 61/06, B29C 71/00, B29C 59/00, B29C 35/00, B29C 31/00, B29C 71/04, B29C 71/02, B29L 11/00

(54) **VERFAHREN ZUR HERSTELLUNG EINES FORMKÖRPERS**
METHOD FOR PRODUCTION OF A MOLDED BODY
PROCÉDÉ DE FABRICATION D'UN ARCTILE MOULE

(30) Priorität: 25.05.2018 DE 102018208273
(43) Veröffentlichungstag der Anmeldung: 14.04.2021
(73) Patentinhaber: Karlsruher Institut für Technologie, 76131 Karlsruhe (DE)
(72) Erfinder: SCHNEIDER, Norbert, 68723 Schwetzingen (DE); KOOS, Christian, 74936 Siegelsbach (DE); WORGULL, Matthias, 76297 Stutensee (DE); DIETRICH, Philipp-Immanuel, 76744 Wörth (DE)
(74) Vertreter: Altmann Stößel Dick Patentanwälte PartG mbB
(86) Internationale Anmeldenummer: PCT/EP2019/063451
(87) Internationale Veröffentlichungsnummer: WO 2019/224349

(56) Entgegenhaltungen:
- TOBIAS MEIER ET AL: "Programmable and self-demolding microstructured molds fabricated from shape-memory polymers", JOURNAL OF MICROMECHANICS & MICROENGINEERING, Bd. 25, Nr. 6, 1. Juni 2015 (2015-06-01), Seite 065017, XP055600503, GB ISSN: 0960-1317, DOI: 10.1088/0960-1317/25/6/065017
- A. Lendlein ET AL: "Shape-Memory Polymers" In: "Reference Module in Materials Science and Materials Engineering", 1. Januar 2016 (2016-01-01), Elsevier, NL, XP055600637, ISBN: 978-0-12-803581-8 DOI: 10.1016/B978-0-12-803581-8.09244-4, das ganze Dokument
- NORBERT SCHNEIDER ET AL: "Nanothermoforming of hierarchical optical components utilizing shape memory polymers as active molds", OPTICAL MATERIALS EXPRESS, Bd. 4, Nr. 9, 20. August 2014 (2014-08-20) , Seite 1895, XP055176286, DOI: 10.1364/OME.4.001895
- David L. Safranski: "Introduction to Shape-Memory Polymers" In: "Shape-Memory Polymer Device Design", 1. Januar 2017 (2017-01-01), Elsevier, XP055600656, ISBN: 978-0-323-37797-3 Seiten 1-22, DOI: 10.1016/B978-0-323-37797-3.00001-4, Abbildung 1; Beispiele 1-7
- LENDLEIN A ET AL: "Formgedächtnispolymere", ANGEWANDTE CHEMIE, WILEY - V C H VERLAG GMBH & CO. KGAA, DE, Bd. 114, Nr. 12, 17. Juni 2002 (2002-06-17), Seiten 2138-2162, XP002251533, ISSN: 0044-8249, DOI: 10.1002/1521-3757(20020617)114:12<2138::AI D-ANGE2138>3.0.CO;2-T

## Beschreibung

### Gebiet der Erfindung

Die vorliegende Erfindung ist auf dem Gebiet der Fertigung von Strukturen, insbesondere von Mikrostrukturen, angesiedelt und betrifft ein Verfahren zur Herstellung eines Formkörpers sowie ein mit diesem Verfahren herstellbaren Formkörper. Derartige Verfahren eignen sich bevorzugt zu einer Herstellung von optischen oder mikrooptischen Bauteilen, lassen sich darüber hinaus aber auch in anderen Anwendungsgebieten einsetzen.

### Stand der Technik

Aus dem Stand der Technik bekannte Fertigungsverfahren für Strukturen, insbesondere für Mikrostrukturen, lassen sich unterteilen einerseits in additive Fertigungsverfahren, welche dazu eingerichtet sind, Strukturen schichtweise aufzubauen, und zu denen insbesondere 3D-Druck oder Zwei-Photonen-Lithographie gehören, und andererseits in Urform- oder Umformverfahren, welche dazu vorgesehen sind, ein gegebenes Material urzuformen bzw. umzuformen, wozu insbesondere Heißprägen, Nano-Imprint und Spritzgießen zählen. Wesentliche Unterschiede zwischen diesen beiden Arten von Fertigungsverfahren liegen in einer Freiheit der Ausformung der herzustellenden Strukturen, einer Fertigungsdauer und damit auch den Stückkosten, und teilweise in möglichen Gesamtgrößen der Strukturen.

Additive Fertigungsverfahren stellen die gewünschten Strukturen in der Regel schichtweise her und erzeugen diese dadurch entlang einer Hauptrichtung. Hiermit lässt sich beinahe jede beliebige Struktur herstellen, wobei die Gesamtgröße durch ein so genanntes "Schreibfeld" und die minimale Auflösung in der Regel durch den verwendeten Werkstoff begrenzt sind. Darüber können weitere Einschränkungen bestehen, etwa in der Zwei-Photonen-Lithographie die Möglichkeit, einen als Schreibstrahl verwendeten Laser in alle drei Raumrichtungen zu fokussieren.

Fertigungsverfahren, bei denen Werkstoffe urgeformt oder umgeformt werden, basieren oft auf einem Werkzeug, welches eine Negativstruktur aufweist, die invers in den Werkstoff übertragen wird. Eine Übertragung der Negativstruktur in den Werkstoff kann hierbei in einer Aufnahme des Werkzeuges durch Aufschmelzen des Werkstoffs oder durch Aushärten eines aushärtbaren Werkstoffs, etwa durch Polymerisation eines Monomers, erfolgen. Derartige Fertigungsverfahren erlauben einen hohen Durchsatz und sind daher besonders wirtschaftlich. Wesentlichen Einschränkungen dieser Verfahren liegen in hohen Kosten für die Herstellung des jeweiligen Werkzeugs sowie in Beschränkungen bezüglich der herstellbaren Geometrien. Ein wesentlich einschränkender Herstellungsschritt ist hierbei ein so genannter "Entformvorgang", bei welchem der aus dem Werkstoff hergestellte Formkörper aus dem Werkzeug entfernt wird.

Nachdem ein Werkstoff im Formwerkzeug seine Form erhalten hat, muss der so hergestellte Formkörper aus dem Formwerkzeug gelöst werden. Dies erfolgt durch Bewegung des Formkörpers entlang einer so genannten "Entformrichtung", die auch als "Entformachse" bezeichnet werden kann, welche bevorzugt derart gewählt ist, dass sich der Formkörper und das Formwerkzeug möglichst ohne Hindernisse voneinander trennen lassen. Allerdings kann die Bewegung des Formkörpers entlang der Entformrichtung die Geometrie des Formkörpers wesentlich einschränken, da der Formkörper hierzu keinen Hinterschnitt bezüglich der Entformrichtung aufweisen darf. Der Begriff "Hinterschnitt" bezeichnet hierbei einen Teil des Formkörpers, welcher nicht entlang der Entformrichtung aus dem Formwerkzeug entformt werden kann. Insbesondere können diejenigen Teile eines Formkörpers als Hinterschnitte bezeichnet werden, für die es keine Entformrichtung gibt. Damit werden die abzuformenden Strukturen auf solche Formen eingeschränkt, welche keine Hinterschnitte aufweisen. Dazu gehören so genannte "2,5D-Strukturen", welche sich aus einer Projektion einer 2D-Form ergeben, wie beispielsweise Gitter, Säulen oder Kanäle für Mikrofluidik. Ferner können Strukturen abgeformt werden, welche entlang mehrerer Entformachsen entformt werden können, beispielsweise sich verjüngende Strukturen wie Pyramiden oder Kegel. Auch unregelmäßige Strukturen lassen sich solange abformen wie alle Strukturen des Formkörpers mindestens eine gemeinsame Entformachse aufweisen. In praktischen Anwendungen wird die Entformachse in der Regel orthogonal zu einer Oberfläche des Formwerkzeugs gewählt, insbesondere um Scherkräfte während des Entformens zu vermeiden.

Zur Herstellung von Strukturen mit Hinterschnitten ist es bekannt, Soft-Imprint-Verfahren oder ein hierarchisches Abformverfahren einzusetzen.

Bei den so genannten Soft-Imprint-Verfahren wird meist ein Formwerkzeug, das auch als "Formeinsatz" bezeichnet werden kann, eingesetzt, für das weiche Kunststoffe, vorzugsweise ein Silikon, insbesondere Polydimethylsiloxan (PDMS), verwendet werden. Aufgrund der elastischen Verformbarkeit des weichen Kunststoffs kann das Formwerkzeug beim Entformvorgang nachgeben und so vermeiden, dass der Formkörper beschädigt wird. Auf diese Weise lassen sich auch Geometrien mit Hinterschnitten herstellen. Allerdings sind derartige Formwerkzeuge nicht so widerstandsfähig wie Formwerkzeuge, welche einen Festkörper, insbesondere aus Metall oder Silizium umfassen, und verschleißen daher bereits nach wenigen Abformungen meist deutlich. So wird ein neues Formwerkzeug benötigt, das erst mit meist kostenintensiven Methoden hergestellt werden muss. Weiterhin schränken elastische Formeinsätze aufgrund einer geringen Temperaturbeständigkeit die Auswahl an abformbaren Materialien deutlich ein. Zudem erreichen elastische Formeinsätze nicht die Formtreue, die bei metallischen Formwerkzeugen als selbstverständlich betrachtet werden. Dies liegt daran, dass sich das elastische Formwerkzeug nicht nur während des Entformvorgangs verformt, sondern bereits während die Aufnahmen des Formwerkzeugs, die auch als "Kavitäten" bezeichnet werden, gefüllt werden. Insbesondere für optische Anwendungen sind diese Abweichungen in der Regel nicht akzeptabel, da sie die Funktion eines optischen Bauteils deutlich verschlechtern können.

Eine Abwandlung hierzu stellen UV-Imprint-Verfahren dar, bei welchen ein meist flüssiges Monomer in die Kavitäten des Formwerkzeugs gegossen wird und unter Bestrahlung mit ultraviolettem Licht auspolymerisiert. Sowohl der Entformvorgang als auch die oben beschriebenen Einschränkungen fester Formeinsätze bleiben unverändert. Darüber hinaus weisen optional vorhandene Fotoinitiatoren funktionsbedingt eine starke Absorption in bestimmten Wellenlängenbereichen, insbesondere im UV-Bereich, auf, welche auch nach erfolgreicher Polymerisation noch vorhanden sind und die Transmission bei diesen Wellenlängen stören können.

Das hierarchische Abformverfahren setzt sich aus einer Kombination aus Heißprägen und Thermoformen zusammen. Hierbei wird zunächst die Oberfläche einer Folie, insbesondere einer Polymerfolie, verändert, wodurch die erste Hierarchiestufe erzeugt wird. Danach wird die Folie als Ganzes verformt, wodurch die zweite Hierarchiestufe erzeugt wird, wobei die Oberflächenstrukturen teilweise horizontal ausgerichtet sein können. Ein Vorteil ist die Anwendbarkeit auf eine hohe Anzahl technischer Polymere, jedoch bestehen Einschränkungen bezüglich der herstellbaren Geometrien. Die hierarchische Struktur muss sich aus Einzelstrukturen mit klar unterscheidbaren Größenskalen zusammensetzen. Ist diese Voraussetzung nicht gegeben, wie beispielsweise bei aufrecht stehenden Linsen, so ist dieses Verfahren nicht oder nur mit erheblichem Aufwand anwendbar. Die mit diesem Verfahren herstellbaren Strukturen weisen zudem Einschränkungen bezüglich eines Einbringens von Hinterschnitten auf. Zwar kann die beschriebene Kombination Einschränkungen des Heißprägens überwinden, dennoch bleibt der Heißprägeschritt auf Strukturen ohne Hinterschnitte beschränkt. Zudem wird die Präzision der Bauteile durch den auf der höheren Größenskala arbeitenden Prozess festgelegt und kann daher unter Umständen die für optische Bauteile notwendigen Spezifikationen nicht erreichen.

DE 10 2014 110 149 A1 offenbart ein Verfahren zur Herstellung eines Formkörpers und einen mit diesem Verfahren hergestellten Formkörper, bei welchem ein strukturierter Verbund auf eine wärmeleitfähige Platte aufgebracht wird. Danach wird die Platte auf die Glasübergangstemperatur des Polymers und unterhalb der permanenten Verformungstemperatur des Formgedächtnispolymers aufgeheizt, wobei ein Formkörper, umfassend den verformten strukturierten Polymerfilm und die strukturierte Folie, entsteht. Der Formkörper kann insbesondere zur Herstellung von Antireflexbeschichtungen, farbpigmentfreien farbigen Flächen oder Mikrokanälen mit strukturierten Wänden verwendet werden. Auch hierauf treffen die erwähnten Einschränkungen auf hierarchische Abformverfahren zu.

DE 10 2013 022 181 A1 offenbart einen Formeinsatz und ein Verfahren zur Herstellung eines mikro- bzw. nanostrukturierten dreidimensional ausgebildeten Formteils unter Verwendung eines Formgedächtnismaterials. Hierbei umfasst das Formwerkzeug ein Formgedächtnismaterial und weist Oberflächenstrukturen in einer temporären Form des Formgedächtnismaterials auf. Das Formwerkzeug wird mit einer aushärtbaren Substanz übergossen, welche auf dem Formwerkzeug aushärtet. Anschließend wird der Formgedächtniseffekt aktiviert und das Formgedächtnismaterial geht in seinen stabilen Zustand in eine flache Form zurück. Auf diese Weise können die Oberflächenstrukturen des Formwerkzeugs aus dem fertigen Bauteil herausgezogen werden. Dieses Verfahren ist jedoch nicht direkt auf Oberflächenstrukturen mit Hinterschnitten anwendbar, da das Formwerkzeug bereits bei der Abformung in seiner temporären Form vorliegen muss.

DE 10 2007 061 342 A1 offenbart einen Artikel aus einem Formgedächtnis-Kompositmaterial, das ein Formgedächtnispolymer sowie ein in dieses eingebettetes magnetisches Material, das in Form von Partikeln vorliegen kann, umfasst, wobei das Formgedächtnispolymer nach einer thermo-mechanischen Programmierung in der Lage ist, temperaturinduziert zumindest einen Formenübergang von einer temporären Form in eine permanente Form zu vollziehen; Verfahren zu seiner Herstellung sowie Verfahren zum Abrufen gespeicherter Formen. Der Artikel weist zumindest zwei, miteinander verbundene Abschnitte auf, die sich durch ein Oberflächen-Volumen-Verhältnis unterscheiden. Hierin wird jedoch keine Herstellung von Strukturen mit Hinterschnitten beschrieben.

US 2010/0123270 A1 offenbart ein weiteres Verfahren zur Herstellung von Strukturen mit Hinterschnitten. Hierzu wird ein Formgedächtnispolymer in einen Überstand einer Kavität eines Bauteils eingebracht, wobei das Formgedächtnispolymer die Form des Hinterschnitts als temporäre Form und eine Form, in der es aus dem Hinterschnitt entformbar ist, als permanente Form aufweist. Somit kann das Formgedächtnispolymer als Werkzeug verwendet werden, das durch einen Schaltvorgang in eine aus dem gefertigten Bauteil entformbare Geometrie übergeführt wird.

JPH02274526 offenbart ein Herstellungsverfahren für ein Produkt mit einem Formgedächtnisharz. Das Produkt hat eine vorbestimmte Form, die sich nur schwer aus der Form lösen lässt. Durch Erhitzen des Produkts auf eine hohe Temperatur und seitliche Verformung kann es dennoch aus der Form gelöst werden.

### Aufgabe der Erfindung

Ausgehend hiervon, besteht die Aufgabe der vorliegenden Erfindung darin, ein Verfahren zur Herstellung eines Formkörpers sowie einen mit diesem Verfahren herstellbaren Formkörper bereitzustellen, welche die aufgeführten Nachteile und Einschränkungen des Standes der Technik zumindest teilweise überwinden.

Insbesondere soll ein Herstellungsverfahren angegeben werden, welches die Vorteile sowohl der additiven Fertigungsverfahren als auch der Umformverfahren in sich vereint und es dadurch ermöglicht, schnell und kostengünstig Strukturen herzustellen, die bisher nicht wirtschaftlich herstellbar waren. Das Verfahren soll zudem auf bereits verfügbaren Vorrichtungen, insbesondere Spritzguss- oder Heißprägemaschinen, einsetzbar sein wodurch aufwändige Umrüstungen der Vorrichtungen entfallen können.

### Offenbarung der Erfindung

Diese Aufgabe wird durch ein Verfahren zur Herstellung eines Formkörpers sowie einen mit diesem Verfahren herstellbaren Formkörper mit den Merkmalen der unabhängigen Patentansprüche gelöst. Vorteilhafte Weiterbildungen, welche einzeln oder in beliebiger Kombination realisierbar sind, sind in den abhängigen Ansprüchen dargestellt.

Im Folgenden werden die Begriffe "haben", "aufweisen", "umfassen" oder "einschließen" oder beliebige grammatikalische Abweichungen davon in nicht-ausschließlicher Weise verwendet. Dementsprechend können sich diese Begriffe sowohl auf Situationen beziehen, in welchen, neben den durch diese Begriffe eingeführten Merkmalen, keine weiteren Merkmale vorhanden sind, oder auf Situationen, in welchen ein oder mehrere weitere Merkmale vorhanden sind. Beispielsweise kann sich der Ausdruck "A hat B", "A weist B auf', "A umfasst B" oder "A schließt B ein" sowohl auf die Situation beziehen, in welcher, abgesehen von B, kein weiteres Element in A vorhanden ist (d.h. auf eine Situation, in welcher A ausschließlich aus B besteht), als auch auf die Situation, in welcher, zusätzlich zu B, ein oder mehrere weitere Elemente in A vorhanden sind, beispielsweise Element C, Elemente C und D oder sogar weitere Elemente.

Weiterhin wird darauf hingewiesen, dass die Begriffe "mindestens ein" und "ein oder mehrere" sowie grammatikalische Abwandlungen dieser Begriffe, wenn diese in Zusammenhang mit einem oder mehreren Elementen oder Merkmalen verwendet werden, ausdrücken sollen, dass das Element oder Merkmal einfach oder mehrfach vorgesehen sein kann, in der Regel lediglich einmalig verwendet wird, beispielsweise bei der erstmaligen Einführung des Merkmals oder Elementes. Bei einer nachfolgenden erneuten Erwähnung des Merkmals oder Elementes wird der entsprechende Begriff "mindestens ein" oder "ein oder mehrere" in der Regel nicht mehr verwendet, ohne Einschränkung der Möglichkeit, dass das Merkmal oder Element einfach oder mehrfach vorgesehen sein kann.

Weiterhin werden im Folgenden die Begriffe "vorzugsweise", "insbesondere", "beispielsweise" oder ähnliche Begriffe in Verbindung mit optionalen Merkmalen verwendet, ohne dass alternative Ausführungsformen hierdurch beschränkt werden. So sind Merkmale, welche durch diese Begriffe eingeleitet werden, optionale Merkmale, und es ist nicht beabsichtigt, durch diese Merkmale den Schutzumfang der Ansprüche und insbesondere der unabhängigen Ansprüche einzuschränken. So kann die Erfindung, wie der Fachmann erkennen wird, auch unter Verwendung anderer Ausgestaltungen durchgeführt werden. In ähnlicher Weise werden Merkmale, welche durch "in einer Ausführungsform der Erfindung" oder durch "in einem Ausführungsbeispiel der Erfindung" eingeleitet werden, als optionale Merkmale verstanden, ohne dass hierdurch alternative Ausgestaltungen oder der Schutzumfang der unabhängigen Ansprüche eingeschränkt werden soll. Weiterhin sollen durch diese einleitenden Ausdrücke sämtliche Möglichkeiten, die hierdurch eingeleiteten Merkmale mit anderen Merkmalen zu kombinieren, seien es optionale oder nicht-optionale Merkmale, unangetastet bleiben.

In einem ersten Aspekt betrifft die vorliegende Erfindung ein Verfahren zur Herstellung eines Formkörpers, umfassend ein mikro-optisches Bauteil, das eine Kavität und/ oder auf einer Oberfläche des Formkörpers hervorstehende Strukturen aufweist. Das erfindungsgemäße Verfahren umfasst hierbei die folgenden Schritte a) bis d), gemäß Anspruch 1, welche vorzugsweise in der angegebenen Reihenfolge durchgeführt werden, wobei aufeinanderfolgende Schritte zumindest teilweise auch gleichzeitig ausgeführt werden können. Ferner können sie durch weitere Schritte ergänzt werden, welche vor, nach und/oder während eines der angegebenen Schritte ausgeführt werden können:
a) eines Formwerkzeugs, welches mit Hinterschnitten, die in dem Formkörper zu Kavitäten und/oder auf der Oberfläche des Formkörpers hervorstehende Strukturen führen, versehen ist, wobei das Formwerkzeug mindestens eine Aufnahme aufweist, in welche mindestens ein Material eingebracht ist wird, wobei das Material mindestens ein Formgedächtnismaterial umfasst, wobei das Formgedächtnismaterial in einem ersten Zustand vorliegt, wobei das Material die Aufnahme des Formwerkzeugs zumindest teilweise derart ausfüllt, dass es an mindestens eine Oberfläche der Aufnahme angrenzt;
b) Erzeugen eines Formkörpers in der Aufnahme des Formwerkzeugs aus dem Material, wobei das Formgedächtnismaterial in einem zweiten Zustand vorliegt, wobei während des zweiten Zustands eine Form in den Formkörper eingeprägt wird;
c) Überführen des Formgedächtnismaterials aus dem zweiten Zustand in einen dritten Zustand, wobei der Formkörper während des dritten Zustands derart verformbar ist, dass ein Entformen des Formkörpers aus der Aufnahme des Formwerkzeugs in Entformrichtung erfolgt; und
d) Zumindest teilweises Wiederherstellen der Form des Formkörpers durch Überführen des Formgedächtnismaterials aus dem dritten Zustand in einen vierten Zustand, wobei der Formkörper während des vierten Zustands die Form gemäß Schritt b) zumindest teilweise wieder annimmt.

Das vorliegende Verfahren besteht daher in einer engen Abstimmung aus Eigenschaften des Formgedächtnismaterials mit den vorgeschlagenen Verfahrensschritten. Der Begriff des "Formgedächtnismaterials" beschreibt hierbei einen Festkörper, der den so genannten "Formgedächtniseffekt" (engl. *shape memory effect*) aufweist, welcher bewirkt, dass der Festkörper entweder selbstständig oder durch äußere Einwirkung seine äußere Form ändern kann. Formgedächtnismaterialien sind allgemein verfügbar und dem Fachmann bekannt, siehe z.B. Angew. Chem. 114, 2002, S. 2138 bis 2162.

Die Formgedächtnismaterialien verfügen somit über mindestens zwei voneinander verschiedene Zustände des Festkörpers, welche einzeln einstellbar sind und welche durch eine entsprechende Einstellung in der Regel eine Änderung der Form des Festkörpers bewirken, wobei die Änderung der Form des Festkörpers entweder selbstständig auftreten kann oder durch eine äußere Einwirkung auf den Festkörper. Diese voneinander verschiedenen Zustände zeichnen sich dadurch aus, dass den Formgedächtnismaterialien in den unterschiedlichen Zuständen unterschiedliche Formen vorgegeben werden können, wobei die unterschiedlichen Formen zumindest teilweise, auch nach späteren Verformungen in anderen Zuständen, wiederherstellbar bleiben. Dies kann häufig durch einen geeigneten molekularen Aufbau des Formgedächtnismaterials hervorgerufen werden. Die in einem einzelnen Zustand eingespeicherte Form des Formgedächtnismaterials kann somit zu einem späteren Zeitpunkt wiederhergestellt werden, indem das Formgedächtnismaterial in einen entsprechenden anderen Zustand gebracht wird oder indem eine Rückstellung in eine zuvor eingespeicherte Form durch eine äußere Einwirkung bewirkt wird. Bis zu der Rückstellung in die zuvor eingespeicherte Form weist das Formgedächtnismaterial darüber mindestens einen weiteren Zustand auf, in welchem mindestens eine der eingespeicherten Formen stabil ist und die zugehörige Form bis zu der Wiederherstellung beibehält.

Unabhängig von seiner Zusammensetzung behält das Formgedächtnismaterial in einem so genannten "temporären Zustand" eine gegebene Form, die auch als "temporäre Form" bezeichnet werden kann, so lange bei, bis es dazu angeregt wird, selbstständig eine andere Form anzunehmen. Diese Art der selbstständigen Formänderung, welche auch als die "Rückstellung" bezeichnet wird, kann durch eine äußere Einwirkung hervorgerufen werden, durch welche das Formgedächtnismaterial in einen entsprechenden Zustand gebracht wird. Im Allgemeinen können Formgedächtnismaterialien mehrere temporäre Zustände aufweisen.

Im Gegensatz hierzu kann das Formgedächtnismaterial über einen so genannten permanenten Zustand" verfügen, in welchem das Formgedächtnismaterial eine dauerhafte Form, die auch als "permanente Form" bezeichnet wird, annimmt oder in welchen das Formgedächtnismaterial durch mindestens eine äußere Einwirkung aufgrund des Formgedächtniseffekts überführt werden kann. Allerdings existieren weder ein Zustand noch eine äußere Einwirkung, welche das Formgedächtnismaterial, ausgehend von der permanenten Form, selbstständig in eine andere Form überführen könnten. Andererseits können jedoch temperatursensitive Formgedächtnismaterialien, insbesondere durch Erhitzen auf mindestens einen festgelegten Temperaturbereich, ausgehend von einer temporären Form, selbstständig in die permanente Form übergehen.

Erfindungsgemäß kann das Formgedächtnismaterial, unabhängig von seiner molekularen Zusammensetzung, einen der folgenden Zustände aufweisen:
**Stabiler Zustand:** In einem so genannten "stabilen Zustand" ist das das Formgedächtnismaterial umfassende Material formstabil. Der Begriff "formstabil" bezieht sich darauf, dass das Material eine bestehende oder vorgegebene Form beibehält, solange keine äußeren Einflüsse darauf einwirken. Als "äußere Einwirkung" wird hierbei insbesondere eine Änderung der Temperatur oder eine Einwirkung eines elektrischen und/oder magnetischen Feldes, insbesondere einer elektrischen Spannung oder eines elektrischen Stromes, eines elektromagnetischen Feldes, insbesondere von Licht aus dem ultravioletten, sichtbaren und/oder infraroten Spektralbereich, von lokalen oder flächigen Kräften, insbesondere von Druckschwankungen; von Teilchenstrahlungen oder von chemischen Substanzen, insbesondere von Lösungsmitteln, auf mindestens einen Teil der Oberfläche des Materials bezeichnet. Unter Ausschluss derartiger äußerer Einwirkungen behält das Material, vorzugsweise dauerhaft, seine vorgegebene Form. Das Material weist den stabilen Zustand vorzugsweise bei Normalbedingungen auf. Der Begriff der "Normalbedingungen" bezieht sich hierbei auf eine Umgebungstemperatur von 20 °C und einen Luftdruck von 1013 hPa.
**Erster Zustand:** In einem so genannten "ersten Zustand" ist das das Formgedächtnismaterial umfassende Material weniger formstabil als das verwendete Formwerkzeug, es wird daher auch als "weicher" als das Formwerkzeug bezeichnet. Insbesondere führt eine Krafteinwirkung zwischen dem Material und dem Formwerkzeug vorzugsweise nicht zu Verformungen des Formwerkzeugs, sondern des Materials; zumindest erfährt das Material daher eine stärkere Verformung als das Formwerkzeug. Im Fall des Materials, das ein Formgedächtnismaterial umfasst, kann dieser Zustand bevorzugt durch Beaufschlagen des Materials mit einer höheren Temperatur oder einer Strahlung erreicht werden, wobei der zugehörige Wert für die Temperatur bzw. für die Strahlungsdosis abhängig von dem eingesetzten Material zu wählen ist.
**Zweiter Zustand:** In einem so genannten "zweiten Zustand" ist eine temporäre oder permanente plastische Umformung des Materials, das ein Formgedächtnismaterial umfasst, zumindest zum Teil möglich. Insbesondere zeichnet sich der zweite Zustand dadurch aus, dass es mindestens einen weiteren Zustand gibt, welcher hier als "vierter Zustand" bezeichnet wird, oder mindestens eine äußere Einwirkung existiert, welche bewirken können, dass sich die in dem zweiten Zustand definierte Form des Formgedächtnismaterials allein durch die Formgedächtniseigenschaft zumindest teilweise wiederherstellen lässt.
**Dritter Zustand:** In einem so genannten "dritten Zustand" ist eine plastische oder elastische Verformung des Materials, welches das Formgedächtnismaterial umfasst, möglich. Insbesondere unterscheidet sich der dritte Zustand dadurch von dem zweiten Zustand, dass sich, ausgehend von Verformungen in dem dritten Zustand, die in dem zweiten Zustand definierte Form allein durch die Formgedächtniseigenschaft wiederherstellen lässt.
**Vierter Zustand:** In dem so genannten "vierten Zustand" liegt das Material, welches das Formgedächtnismaterial umfasst, derart vor oder erfährt eine derartige äußere Einwirkung, dass sich die in dem zweiten Zustand definierte Form des Formgedächtnismaterials allein durch die Formgedächtniseigenschaft zumindest teilweise wiederherstellen lässt. Wie bereits erwähnt, bezeichnet hier die "äußere Einwirkung" insbesondere eine Änderung der Temperatur oder eine Einwirkung eines elektrischen und/oder magnetischen Feldes, insbesondere einer elektrischen Spannung oder eines elektrischen Stromes, eines elektromagnetischen Feldes, insbesondere von Licht aus dem ultravioletten, sichtbaren und/oder infraroten Spektralbereich, von lokalen oder flächigen Kräften, insbesondere von Druckschwankungen; von Teilchenstrahlungen oder von chemischen Substanzen, insbesondere von Lösungsmitteln, auf mindestens einen Teil der Oberfläche des Materials. Je nach eingesetztem Formgedächtnismaterial können der vierte Zustand oder die beschriebene äußere Einwirkung entweder so lange gehalten werden, bis die Rückstellung in die Form einsetzt oder bis die Rückstellung in die Form abgeschlossen ist.

In einer besonderen Ausgestaltung der vorliegenden Erfindung können hierbei der erste Zustand und der dritte Zustand zueinander identisch sein und/oder der dritte Zustand und der vierte Zustand zueinander identisch sein und/oder der erste Zustand und vierte Zustand zueinander identisch sein.

In einer besonderen Ausgestaltung kann einer oder mehrerer der genannten Zustände eine lokale Begrenzung aufweisen. Vorzugsweise kann das Material hierbei werkzeugseitig einen anderen Zustand aufweisen als auf der dem Formwerkzeug abgewandten Seite. Diese Ausgestaltung kann insbesondere eine Ausführung des Entformvorgangs begünstigen. Weiterhin kann der Formkörper dadurch über eine zusätzliche Funktionalität verfügen, da sich Oberflächeneigenschaften so bevorzugt auf einen bestimmten Bereich einschränken lassen, beispielsweise ein Auftreten eines lokal begrenzten Benetzungsverhaltens oder lokal begrenzte optische Eigenschaften.

In einer besonders bevorzugten Ausgestaltung können Formgedächtnispolymere, die mindestens zwei voneinander getrennte Temperaturbereiche aufweisen, in denen jeweils Umformungen in einen anderen Zustand mit einer bestimmten Form auftreten können, für das vorliegende Verfahren verwendet werden. Derartige Formgedächtnispolymere können über jeweils zwei Temperaturbereiche verfügen, in welchen eine plastische Verformung stattfinden kann. Oberhalb einer Temperatur Tₜᵣₐₙₛ kann eine temporäre Form definiert werden, welche unterhalb von Tₜᵣₐₙₛ stabil ist. Wird das Formgedächtnispolymer auf eine Temperatur oberhalb von Tₜᵣₐₙₛ erhitzt, stellt es sich selbstständig in seine permanente Form zurück. Andererseits kann die permanente Form über plastische Verformungen oberhalb von Tₚₑᵣₘ definiert werden. Im Vergleich hierzu weisen klassische technische thermoplastische Polymere lediglich einen einzigen Temperaturbereich auf, in welchem plastische Umformungen stattfinden können. Je nach Art des verwendeten Formgedächtnispolymers kann eine unterschiedliche Anzahl derartiger Temperaturbereiche existieren, wobei sich die Temperaturbereiche über verschiedene Temperaturen erstrecken können.

In einer besonders bevorzugten Ausgestaltung ist das Formgedächtnismaterial ein temperatursensitives Formgedächtnismaterial. Hierfür eignen sich insbesondere Formgedächtnispolymere, vorzugsweise ein thermoplastisches Polyurethan oder ein Flüssigkristallpolymer. Für das vorliegende Verfahren eignen sich insbesondere die Formgedächtnispolymere Tecoflex^{®} (TFX) oder Tecoplast^{®} (TPL). Andere Arten von Formgedächtnispolymeren, welche die oben aufgeführten Eigenschaften aufweisen, können jedoch ebenfalls verwendet werden.

Ohne Beschränkung auf die nachfolgende theoretische Betrachtungsweise, können derartige unterschiedliche Temperaturbereiche auf dem molekularen Aufbau der Formgedächtnispolymere beruhen. Die Moleküle der Formgedächtnispolymere können so genannte "harte Segmente" und "weiche Segmente", die auch als "Netzpunkte" und "Schaltpunkte" bezeichnet werden können, aufweisen, welche für die permanente Form und für temporäre Formen verantwortlich sein können. Beide Segmente können verschiedene Mechanismen nutzen. Die Netzpunkte können sich aus kovalenten Bindungen oder intermolekularen Kräfte, die beispielsweise von kristallinen Bereichen herrühren, ergeben. Die Schaltsegmente können andere kristalline Bereiche oder andere Arten von Bindungen sein, welche das Formgedächtnispolymer gegen eine innere Spannung der Netzpunkte in der temporären Form fixieren können. Wird das Formgedächtnispolymer erwärmt, so können sich diese Bindungen auflösen, wodurch das Formgedächtnispolymere durch die von den Netzpunkten gehaltene innere Spannung wieder in seine permanente Form zurückgestellt wird.

Gemäß Schritt a) erfolgt ein Bereitstellen eines Formwerkzeugs, welches mindestens eine Aufnahme aufweist, in welche mindestens ein Material eingebracht ist. Der Begriff des "Formwerkzeugs" oder "Formeinsatzes" betrifft ein mechanisches Werkzeug, welches eine Negativstruktur aufweist, die invers in ein Material übertragen werden kann. Hierbei befindet sich das Material in einer Einrichtung des Formwerkzeugs, welche als Aufnahme bezeichnet wird. Der Begriff "Aufnahme" bezieht sich hierbei auf eine sich in dem Formwerkzeug befindliche Struktur, welche, in einer ersten Ausgestaltung, als Aussparung in einer Oberfläche des Formwerkzeugs oder, in einer weiteren Ausgestaltung, als eine von der Oberfläche des Formwerkzeugs hervorstehende Struktur, oder als beliebige Kombination der beiden Ausgestaltungen bezeichnet werden kann. Somit kann das Formwerkzeug in einem damit hergestellten Formkörper Kavitäten und/oder auf der Oberfläche des Formkörpers hervorstehende Strukturen erzeugen. Das vorliegende Erfindungsgemäß wird ein Formwerkzeug eingesetzt, das Strukturen mit Hinterschnitten aufweist, die in dem Formkörper zu Kavitäten und/oder auf der Oberfläche des Formkörpers entsprechend zu hervorstehende Strukturen führt.

Zu einer möglichst formgetreuen Übertragung der Negativstruktur auf das Material füllt das Material die Aufnahme des Formwerkzeugs zumindest teilweise, vorzugsweise vollständig, derart aus, dass es an eine Oberfläche der Aufnahme angrenzt, um so eine möglichst genaue Abbildung der Negativstruktur der Aufnahme des Formwerkzeugs zu ermöglichen. Wie bereits erwähnt, umfasst das Material mindestens ein Formgedächtnismaterial, wobei das Formgedächtnismaterial in dem ersten Zustand vorliegt, so dass es weniger formstabil als das verwendete Formwerkzeug ist und daher eine Krafteinwirkung zwischen dem Material und dem Formwerkzeug bevorzugt nicht zu Verformungen des Formwerkzeugs, sondern des Materials führt. Auf diese Weise kann eine Beschädigung des Formwerkzeugs bei einer Befüllung mit dem Material unterbunden werden.

Das Formwerkzeug kann hierbei insbesondere ein Formwerkzeug sein, das ein Metall, Silizium, eine Siliziumverbindung, insbesondere Siliziumdioxid, oder ein Polymer umfasst. Andere Arten von Formwerkzeugen sind jedoch möglich. Vorzugsweise kann das Formwerkzeug mittels 3D-Druck herstellbar sein, wobei der 3D-Druck in dem zugehörigen Werkstoff, insbesondere in dem Metall oder dem Polymer ausgeführt wurde. Alternativ oder zusätzlich kann das Formwerkzeug lithografisch, bevorzugt 3D-lithografisch, insbesondere mittels Zwei-Photonen-Lithografie und/oder mittels Interferenzlithografie, und/oder galvanisch aus einem bestehenden Formkörper herstellbar sein. Weitere Arten der Herstellung des Formwerkzeugs sind denkbar.

Wie bereits erwähnt, umfasst das Material, welches während Schritt a) bereitgestellt wird, das mindestens eine Formgedächtnismaterial. Hierzu wird mindestens ein Formgedächtnismaterial oder eine Mischung von verschiedenen Materialien, von welchen mindestens eines ein Formgedächtnismaterial ist, direkt in die mindestens eine Aufnahme des Formwerkzeugs eingebracht. Alternativ oder zusätzlich kann mindestens ein Ausgangsmaterial, insbesondere mindestens ein so genannter "Precursor", in die mindestens eine Aufnahme des Formwerkzeugs eingebracht werden, wobei das Ausgangsmaterial vor Schritt b) in einem zusätzlichen Verfahrensschritt zumindest teilweise, vorzugsweise vollständig, in das mindestens eine Formgedächtnismaterial überführt werden kann. Darüber hinaus kann zumindest eine Komponente des während Schritt a) bereitgestellten Materials Partikel umfassen, wobei die Partikel vorzugsweise ausgewählt sind aus Mikropartikeln oder Nanopartikeln und insbesondere nicht-magnetische Partikel sind. Der Begriff "Partikel" bezieht sich auf Teilchen mit einem Durchmesser über einen begrenzten, vorzugsweise eng eingegrenzten Bereich, wobei "Mikropartikel" typischerweise einen Durchmesser von 0.1 µm bis 100 µm und "Nanopartikel" typischerweise einen Durchmesser von 1 nm bis 100 nm aufweisen. Bei den im vorliegenden Verfahren eingesetzten Partikeln handelt es sich vorzugsweise um Partikel, welche Kohlenstoff, Siliziumdioxid und/oder ein Metall aufweisen. Zum Beispiel können die Partikel Goldpartikel, Glaspartikel oder Kohlenstoffnanoröhren sein. Andere Arten von Partikeln sind möglich. Die genannten Partikel können hierbei verschiedene Funktionalitäten aufweisen. Goldpartikel können beispielsweise zur Färbung eingesetzt werden und nutzen plasmonische Effekte hierzu. Weitere Metallpartikel können zur Verbesserung der elektrischen und thermischen Leitfähigkeit eingesetzt werden. Kohlenstoffnanoröhren können ebenfalls zu diesem Zweck einsetzt werden, können darüber hinaus aber auch die mechanische Stabilität des Bauteils erhöhen, in dem sie eingebettet sind. Kohlenstaub oder Kohlenstoffnanopartikel können zur Lichtabsorption beigemischt werden. Insbesondere können die Partikel optisch aktive Materialien umfassen, wie sie beispielsweise zur Herstellung organischer Laser verwendet werden. Ein Einsatz optisch aktiver Partikel ermöglicht es, Strukturen herzustellen, die Laserlicht emittieren können, wenn sie von außen durch geeignete Maßnahmen gepumpt werden.

Unabhängig von der Art der Bereitstellung, ist die mindestens eine Aufnahme des Formwerkzeugs mit dem Material, welches das mindestens eine Formgedächtnismaterial umfasst, zum Abschluss von Schritt a) zumindest teilweise, vorzugsweise vollständig, insbesondere an ihrer Oberfläche gefüllt, bevor gemäß Schritt b) ein Erzeugen eines Formkörpers in der Aufnahme des Formwerkzeugs aus dem Material erfolgt. Auf diese Weise kann sichergestellt werden, dass eine möglichst formtreue Abbildung der durch die mindestens eine Aufnahme festgelegte mindestens eine Negativform in dem Formwerkzeug auf den herzustellenden Formkörper erfolgen kann. Zur Erzeugung des Formkörpers liegt das das Formgedächtnismaterial in einem zweiten Zustand vor, wobei in das Formgedächtnismaterial während des zweiten Zustands eine Form in den erzeugten Formkörper eingeprägt wird. Das Überführen des Formgedächtnismaterials aus dem ersten Zustand in den zweiten Zustand kann hierbei noch während Schritt a), in Form eines Zwischenschritts zwischen Schritt a) und Schritt b) und/oder während Schritt b) erfolgen. Insbesondere kann das Überführen des Formgedächtnismaterials, vorzugsweise eines temperatursensitiven Formgedächtnismaterials, aus dem ersten Zustand in den zweiten Zustand durch Beaufschlagen des Materials mit einer gegenüber dem ersten Zustand erhöhten Temperatur erfolgen. Alternativ kann das Material, welches das Formgedächtnismaterial umfasst, bereits unter der höheren Temperatur in die Aufnahme des Formwerkzeugs eingefüllt werden, so dass das Formgedächtnismaterial bereits zu Beginn von Schritt b) bei der höheren Temperatur vorliegt. Andere Ausgestaltungen sind möglich.

Während des zweiten Zustands, welchen das Formgedächtnismaterial während Schritt b) annimmt, wird somit eine Form, die auch als "Zielform" bezeichnet werden kann und die vorzugsweise die permanente Form des Formgedächtnismaterials ist, in den Formkörper eingeprägt. Die Form kann eine beliebige Ausgestaltung annehmen und insbesondere einen Hinterschnitt oder mindestens eine Struktur mit einem Aspektverhältnis von mindestens 10, bevorzugt von mindestens 100 aufweisen. Wie eingangs erwähnt, bezeichnet der Begriff "Hinterschnitt" hierbei einen Teil des Formkörpers, welcher sich nicht entlang einer Entformrichtung aus dem Formwerkzeug entformen lässt. Beispielsweise kann der Formkörper über Strukturen wie Pyramiden oder Kegel verfügen, welche sich zur Oberfläche des Formkörpers hin verjüngen. Weiterhin bezeichnet der Begriff des "Aspektverhältnisses" einen Quotienten, welcher sich aus einer Höhe einer Struktur in Bezug auf eine hierzu laterale Ausdehnung der Struktur, welche insbesondere auf einer Oberfläche des Formkörpers angebracht sein kann. Beispielsweise kann ein Formkörper über säulenförmige Erhebungen mit einer Höhe und einer Basis verfügen, welche auf dessen Oberfläche angebracht sind, wobei die Höhe die Basis um einen Faktor von mindestens 10, bevorzugt von mindestens 100 übertreffen kann. Andere Ausgestaltungen sind jedoch möglich.

Um jedoch einen Entformvorgang vornehmen zu können, erfolgt gemäß Schritt c) ein Überführen des Formgedächtnismaterials aus dem zweiten Zustand in einen dritten Zustand, in welchem der Formkörper derart verformbar ist, dass ein Entformen des Formkörpers aus der Aufnahme des Formwerkzeugs ermöglicht wird. Dabei kann die in Schritt b) erfolgte Einprägung der Form des Formkörpers, die auch als "Formprogrammierung" bezeichnet werden kann, teilweise erhalten, wobei der Formkörper in dem dritten Zustand des Formgedächtnismaterials eine höhere Elastizität im Vergleich zu dem zweiten Zustand aufweist, so dass die Verformbarkeit des Formkörpers insbesondere an einer Stelle an der Oberfläche des Formkörpers, an welcher ein Hinterschnitt oder eine Struktur mit einem Aspektverhältnis von mindestens 10 auftritt, dennoch eine Entformung des Formkörpers aus der entsprechenden Aufnahme des Formwerkzeugs ermöglicht wird.

In einer bevorzugten Ausgestaltung kann das Überführen des Formgedächtnismaterials aus dem zweiten Zustand in den dritten Zustand während Schritt c) durch eine äußere Einwirkung, insbesondere durch ein Beaufschlagen des Formkörpers während Schritt c) mit Licht, durch ein Beaufschlagen des Formkörpers während Schritt c) mit einer gegenüber dem zweiten Zustand verringerten Temperatur oder durch ein Beaufschlagen des Formkörpers während Schritt c) mit einer gegenüber dem zweiten Zustand verringerten Krafteinwirkung erfolgen. Eine Kombination der ausgeführten äußeren Einwirkungen oder weitere Arten von äußeren Einwirkungen ist möglich, insbesondere abhängig von dem ausgewählten Formgedächtnismaterial.

Allerdings kann sich durch das Entformen des Formkörpers gemäß Schritt c) die Form des Formkörpers zumindest teilweise, vorzugsweise vollständig, derart ändern, dass sie von der in Schritt b) einprägten Form (Formprogrammierung) des Formkörpers abweichen kann. Gemäß Schritt d) erfolgt somit ein zumindest teilweises, vorzugsweise vollständiges, Wiederherstellen der Form (Zielform) des Formkörpers durch ein Überführen des Formgedächtnismaterials aus dem dritten Zustand in einen vierten Zustand, wobei sich der vierten Zustand des Formgedächtnismaterials dadurch auszeichnet, dass der Formkörper die während Schritt b) einprägte Form (Formprogrammierung) zumindest teilweise, vorzugsweise vollständig, wieder annimmt. Das Überführen des Formgedächtnismaterials aus dem dritten Zustand in den vierten Zustand kann hierbei vorzugsweise durch eine äußere Einwirkung, insbesondere je nach ausgewähltem Formgedächtnismaterial, durch ein Beaufschlagen des Formkörpers während Schritt d) mit Licht oder durch ein Beaufschlagen des Formkörpers während Schritt d) mit einer gegenüber dem dritten Zustand erhöhten Temperatur erfolgen. Alternativ kann das Überführen des Formgedächtnismaterials aus dem dritten Zustand in den vierten Zustand durch ein Belassen des Formkörpers während Schritt d) bei Normalbedingungen erfolgen.

In einer besonderen Ausgestaltung des vorliegenden Verfahrens kann eine so genannte "Selbstheilung" einer im Anschluss an Schritt d) erfolgten weiteren Verformung der Form (Zielform) des Formkörpers vorgenommen werden. Voraussetzung hierfür ist, dass absichtliche oder versehentlich zugefügte Verformungen nicht im zweiten Zustand des Formgedächtnismaterials erfolgen. An die Verformung anschließend kann das Formgedächtnismaterial wieder in den vierten Zustand überführt werden, in welchem der Formkörper dann die Form (Zielform) zumindest teilweise, vorzugsweise vollständig, wieder annimmt. Auf diese Weise lassen sich absichtlich vorgenommene oder versehentlich aufgetretene Verformungen eines gemäß dem vorliegenden Verfahren erzeugten Formkörpers ganz oder zumindest teilweise wieder beseitigen.

In einem weiteren Aspekt betrifft die vorliegende Erfindung einen Formkörper, welcher mit dem vorliegenden Verfahren herstellbar ist oder damit hergestellt wurde. Insbesondere kann der Formköper hierbei mindestens einen Hinterschnitt oder mindestens eine Struktur mit einem Aspektverhältnis von mindestens 10, bevorzugt von mindestens 100, aufweisen.

Für weitere Einzelheiten in Bezug auf den Formkörper wird auf die übrige Beschreibung des Verfahrens verwiesen.

### Vorteile der Erfindung

Die vorliegende Erfindung weist eine Reihe von Vorteilen gegenüber den aus dem Stand der Technik bekannten Fertigungsverfahren für Strukturen, insbesondere für Mikrostrukturen, auf. Durch den hier vorgeschlagenen Einsatz der verschiedenen Zustände der Formgedächtnispolymere in Verbindung mit hierauf abgestimmten Verfahrensschritten lassen sich, wie unten näher erläutert wird, Hinterschnitte direkt abformen. Insbesondere eignen sich Formgedächtnispolymere, welche eine hohe Transmission zumindest über den sichtbaren Spektralbereich und, bevorzugt, auch über das nahe Infrarot aufweisen. Dadurch sind die optischen Eigenschaften - im Gegensatz zur UV-Lithografie - nicht durch in dem Material verbleibende Fotoinitiatoren eingeschränkt. Außerdem kann das vorgeschlagene Verfahren mit herkömmlichen Formwerkzeugen aus Metall, welche abnutzungsresistent sind, durchgeführt werden.

Insbesondere im Unterschied zur DE 10 2007 061 342 A1 ist erfindungsgemäß eine Herstellung von Strukturen mit Hinterschnitten möglich. Die darin aufgeführte Möglichkeit zur Erzeugung der permanenten Form der thermoplastischen Formgedächtnispolymere durch Spritzguss ist bereits seit langem bekannt. Dies trifft auch auf die dort beschriebene Programmierung des Formgedächtnispolymers zu, insbesondere auf das kalte Verstrecken, das bei der Herstellung von Hinterschnitten nur in Ausnahmefällen einsetzbar ist. Zudem erfolgt dort die Rückstellung des Formgedächtnispolymers - im Unterschied zum vorliegenden Verfahren - mittels eines oder mehrerer Magnetfelder, die auf das in das Formgedächtnispolymer eingebettete magnetische Material einwirken. Während das Material in der DE 10 2007 061 342 A1 ein Kompositmaterial ist, das ein Formgedächtnispolymer und ein in dieses eingebettetes magnetisches Material, das in Form von Partikeln vorliegen kann, umfasst, ist das Material gemäß der vorliegenden Erfindung, d.h. sowohl das mindestens eine Formgedächtnismaterial als auch die optional darin eingebrachten Partikel, vorzugsweise nicht-magnetisch und kann daher aus einer weitaus größeren Anzahl von Substanzen ausgewählt werden.

Im weiteren Unterschied zum Stand der Technik bietet der hier eingesetzte Formgedächtniseffekt mit der Möglichkeit einer so genannten "Selbstheilung" einen weiteren Vorteil. Die erfindungsgemäß erzeugten Strukturen erhalten ihre Form als eine wiederherstellbare Form, in einer Ausprägung als die permanente Form des Materials. Wird ein Formkörper nach seiner Herstellung gemäß Schritt d) absichtlich oder versehentlich in einem Zustand, der nicht der zweite ist, in der Ausführung mit Tecoflex^{®} oder Tecoplast^{®} bei Temperaturen unterhalb der permanenten Verformungstemperatur Tₚₑᵣₘ verformt, so bleibt die eingeprägte Form davon unberührt. Folglich kann sich der Formkörper durch Überführen in de zweiten Zustand, insbesondere durch Erhitzen, wieder in seine ursprüngliche Form zurückstellen, wodurch die Struktur des Bauteils als Ganzes wiederhergestellt wird.

### Kurze Beschreibung der Figuren

Weitere Einzelheiten und Merkmale der vorliegenden Erfindung ergeben sich aus der nachfolgenden Beschreibung von bevorzugten Ausführungsbeispielen, insbesondere in Verbindung mit den abhängigen Ansprüchen. Hierbei können die jeweiligen Merkmale für sich alleine oder zu mehreren in Kombination miteinander verwirklicht sein. Die Erfindung ist nicht auf die Ausführungsbeispiele beschränkt.

Die Ausführungsbeispiele sind schematisch in den nachfolgenden Figuren dargestellt. Hierbei bezeichnen gleiche Bezugsziffern in den Figuren gleiche oder funktionsgleiche Elemente bzw. hinsichtlich ihrer Funktionen einander entsprechende Elemente. Im Einzelnen zeigen:
- Figur 1: eine schematische Darstellung des vorgeschlagenen Verfahrens zur Herstellung eines Formkörpers gemäß den Schritten a) bis d) in den Figuren 1a bis 1d;
- Figur 2: eine schematische Darstellung der zeitlichen Veränderung der Prozessparameter Kraft F [N] (links; durchgezogene Linie) und Temperatur T [°C] (rechts; gestrichelte Linie) über den zeitlichen Ablauf t [s] einer bevorzugten Ausführung des vorliegenden Verfahrens;
- Figur 3: eine rasterelektronische Aufnahme einer Struktur, die mit dem vorliegenden Verfahren hergestellt wurde, (Figur 3a) und eine Darstellung der messtechnischen Erfassung ihrer Formtreue (Figur 3b); und
- Figur 4: rasterelektronische Aufnahmen von weiteren Strukturen, welche mit dem vorliegenden Verfahren hergestellt, anschließend verformt und schließlich durch Selbstheilungsfähigkeit wiederhergestellt wurden (Figur 4a) sowie eine Darstellung der messtechnischen Erfassung ihrer Oberfläche nach der Wiederherstellung durch die Selbstheilungsfähigkeit (Figur 4b).

### Beschreibung der Ausführungsbeispiele

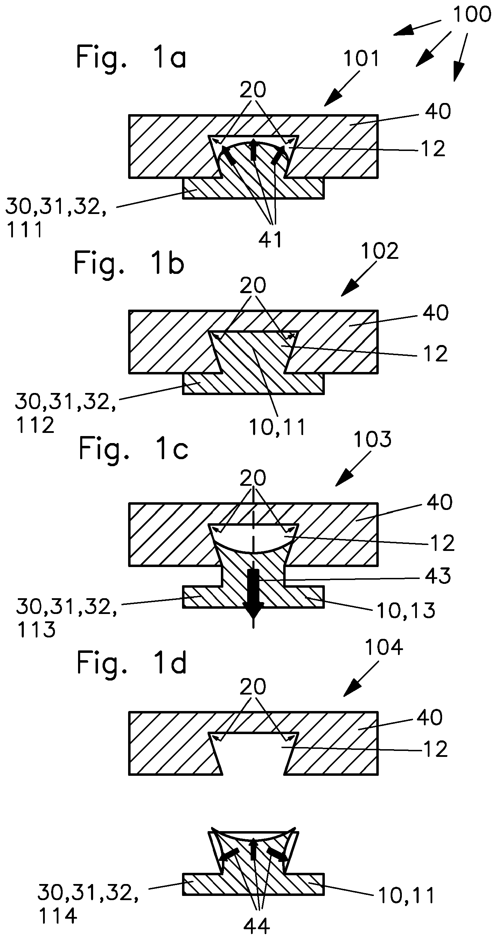

Figur 1 zeigt eine schematische Darstellung des vorgeschlagenen Verfahrens 100 zur Herstellung eines Formkörpers 10.

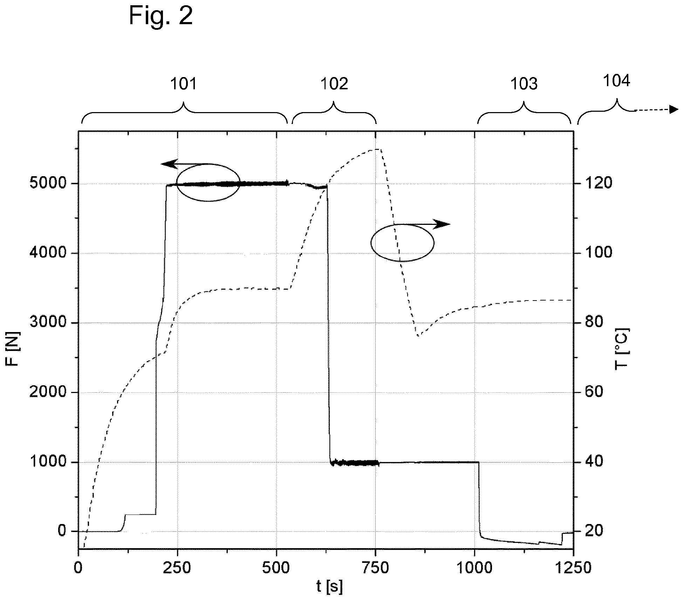

Wie in Figur 1a schematisch dargestellt, wird gemäß Schritt a) 101 ein Formwerkzeug 40 bereitgestellt, welches mindestens eine Aufnahme 12, die auch als "Kavität" bezeichnet werden kann, aufweist, in die mindestens ein Material 30 eingebracht ist. Das Material 30 umfasst hierbei mindestens ein Formgedächtnismaterial 31 oder eine Mischung 32 von verschiedenen Materialien, von welchen mindestens eines ein Formgedächtnismaterial 31 ist, welche direkt in die Aufnahme 12 des Formwerkzeugs 40 eingebracht werden können. Alternativ oder zusätzlich kann mindestens ein Ausgangsmaterial 33, insbesondere ein Precursor, in die Aufnahme 12 des Formwerkzeugs 40 eingebracht werden, wobei das mindestens eine Ausgangsmaterial 33 vor oder während Schritt b) 102 in einem zusätzlichen Verfahrensschritt ganz oder zumindest teilweise in mindestens ein Formgedächtnismaterial 31 überführt werden kann. In Versuchen, deren Ergebnisse in den Figuren 2-4 dargestellt sind, umfasste das Formgedächtnismaterial 31 das Formgedächtnispolymer Tecoflex^{®}. Andere Formgedächtnismaterialien, insbesondere weitere Formgedächtnispolymere, sind ebenfalls möglich.

Darüber hinaus kann zumindest eine Komponente des während Schritt a) 101 bereitgestellten Materials 30 Partikel, insbesondere Mikropartikel oder Nanopartikel, bevorzugt nicht-magnetische Partikel, umfassen, welche vorzugsweise Kohlenstoff, Siliziumdioxid und/oder ein Metall aufweisen. Zum Beispiel können die Partikel Goldpartikel, Glaspartikel oder Kohlenstoffnanoröhren sein. Insbesondere können die Partikel optisch aktive Partikel sein.

Während Schritt a) 101 liegt das Formgedächtnismaterial 31 in einem ersten Zustand 111 vor, in welchem das Material 30, welches das Formgedächtnismaterial 31 oder das mindestens eine Ausgangsmaterial 33 umfasst, weniger formstabil als das Formwerkzeug 40. Auf diese Weise kann verhindert werden, dass das Formwerkzeug 40 durch eine Befüllung mit dem Material 30 beschädigt wird. Die Pfeile in Figur 1a deuten eine Ausbreitungsrichtung und/oder Fließrichtung 41 an, entlang der das Material 30 derart in die Aufnahme 12 des Formwerkzeugs 40 eingebracht wird, dass es die Aufnahme 12 zumindest teilweise so ausfüllt, dass es schließlich an mindestens eine Oberfläche der Aufnahme 12 angrenzt. Durch diese Art der Befüllung der Aufnahme 12 des Formwerkzeugs 40 kann sichergestellt werden, dass eine möglichst formtreue Abbildung der durch die Aufnahme 12 festgelegte Negativform in dem Formwerkzeug 40 auf den herzustellenden Formkörper 10 erfolgen kann.

In Figur 1b ist der Ablauf von Schritt b) 102 schematisch dargestellt. Hierbei erfolgt ein Erzeugen eines Formkörpers 10 in der Aufnahme 12 des Formwerkzeugs 40 aus dem Material 30. Hierzu wird das Formgedächtnismaterial 31 in einen zweiten Zustand 112 gebracht, in welchem die Form 11 des Formkörpers 10 derart eingeprägt wird, dass sie zu einem späteren Zeitpunkt nach einer Verformung des Formkörpers 10 zumindest teilweise durch die Formgedächtniseigenschaft wiederhergestellt werden kann. Ein Überführen des Formgedächtnismaterials 31 aus dem ersten Zustand 111 in den zweiten Zustand 112 kann hierbei noch während Schritt a) 101, in Form eines Zwischenschritts zwischen Schritt a) und Schritt b) und/oder während Schritt b) 102 erfolgen. Insbesondere kann hierfür ein temperatursensitives Formgedächtnismaterial 31 eingesetzt werden, das durch Beaufschlagen des Materials 30 mit einer gegenüber dem ersten Zustand 111 erhöhten Temperatur aus in den zweiten Zustand 112 überführt werden kann. Beispielsweise kann das Material 30, welches das Formgedächtnismaterial 31 umfasst, unter Normalbedingungen, d.h. bei 20 °C, in die Aufnahme 12 des Formwerkzeugs 40 eingefüllt und hieran anschließend auf eine höhere Temperatur, zum Beispiel auf 135 °C, aufgeheizt werden. Alternativ kann das Material 30, welches das Formgedächtnismaterial 31 umfasst, bereits unter der höheren Temperatur, zum Beispiel bei 135 °C, in die Aufnahme 12 des Formwerkzeugs 40 eingefüllt werden, so dass das Formgedächtnismaterial 31 bereits zu Beginn von Schritt b) 102 bei der höheren Temperatur vorliegt. Andere Vorgehensweisen sind möglich. Während des zweiten Zustands 112, welchen das Formgedächtnismaterial 31 während Schritt b) 102 annimmt, wird somit die Form 11 in den Formkörper 10 eingeprägt. Die Form 11 des Formkörpers 10 kann eine beliebige Ausgestaltung annehmen und insbesondere einen Hinterschnitt 20 oder eine Struktur mit einem Aspektverhältnis von mindestens 10 aufweisen. Andere Ausgestaltungen sind jedoch möglich.

Wie Figur 1c schematisch zeigt, wird gemäß Schritt c) 103 der Formkörper 10 aus dem Formwerkzeug 40 in Entformrichtung 43 entformt. Um jedoch einen Entformvorgang vornehmen zu können, erfolgt gemäß Schritt c) 103 zunächst ein Überführen des Formgedächtnismaterials 31 aus dem zweiten Zustand 112 in einen dritten Zustand 113, in welchem der Formkörper 10 derart verformbar ist, dass ein Entformen des Formkörpers 10 aus der Aufnahme 12 des Formwerkzeugs 40 entlang der Entformrichtung 43 möglich wird. Dabei kann die in Schritt b) 102 erfolgte Einprägung der Form 11 des Formkörpers 10, die auch als "Formprogrammierung" bezeichnet werden kann, zumindest teilweise erhalten, wobei der Formkörper 10 in dem dritten Zustand 113 des Formgedächtnismaterials 31 eine höhere Elastizität im Vergleich zu dem zweiten Zustand 112 aufweist. Aufgrund der so gegebenen Verformbarkeit des Formkörpers 10 kann somit die Entformung des Formkörpers 10 aus der Aufnahme 12 des Formwerkzeugs 40 in die Entformrichtung 43 auch dann ermöglicht werden, wenn an einer Stelle der Oberfläche des Formkörpers 10 ein Hinterschnitt 20 oder eine Struktur mit einem Aspektverhältnis von mindestens 10 auftritt.

In einer bevorzugten Ausführung kann das während Schritt c) vorgenommene Überführen des Formgedächtnismaterials 31 aus dem zweiten Zustand 112 in den dritten Zustand 113 durch eine äußere Einwirkung erfolgen, Hierzu können sich insbesondere ein Beaufschlagen des Formkörpers 10 mit Licht, ein Beaufschlagen des Formkörpers 10 mit einer gegenüber dem zweiten Zustand 112 verringerten Temperatur oder durch ein Beaufschlagen des Formkörpers 10 mit einer gegenüber dem zweiten Zustand verringerten Krafteinwirkung, beispielsweise durch Anlegen eines Unterdrucks, erfolgen. Insbesondere abhängig von dem eingesetzten Formgedächtnismaterial 31, ist auch eine Kombination der ausgeführten äußeren Einwirkungen oder weitere Arten von äußeren Einwirkungen möglich. Weiterhin können die in dem Formgedächtnismaterial 31 auftretenden Zustände auch lokal begrenzt sein, beispielsweise kann formwerkzeugseitig der zweite Zustand 112 vorliegen, während auf der vom Formwerkzeug 40 abgewandten Seite des Formgedächtnismaterials 31 der stabile Zustand 110 vorliegt.

Figur 1d zeigt schematisch den Ablauf des Schritts d) 104, in welchem die in Figur 1b dargestellte Form 11 des Formkörpers 10 zumindest teilweise wiederhergestellt wird. Hierzu wird das Formgedächtnismaterial 31 aus dem dritten Zustand 113 in einen vierten Zustand 114 gebracht. Das Überführen des Formgedächtnismaterials 31 aus dem dritten Zustand 113 in den vierten Zustand 114 während Schritt d) kann vorzugsweise durch ein Belassen des Formkörpers 10 während Schritt d) bei Normalbedingungen erfolgen. Alternativ kann eine äußere Einwirkung, je nach ausgewähltem Formgedächtnismaterial 31, insbesondere ein Beaufschlagen des Formkörpers 10 mit einer elektromagnetischen Strahlung, insbesondere, Licht, ein Beaufschlagen des Formkörpers 10 mit einer gegenüber dem dritten Zustand 113 erhöhten Temperatur und/oder ein Beaufschlagen des Formkörpers 10 mit einem Lösungsmittel vorgenommen werden.

Während des vierten Zustands 114 kann der Formkörper 10, wie die Pfeile in Rückstellrichtung 44 in der Figur 1d schematisch darstellen, aufgrund der Formgedächtniseigenschaft des darin umfassten Formgedächtnismaterials 31 somit die während Schritt b) 102 eingeprägte Form 11 selbstständig ganz oder zumindest teilweise wieder anzunehmen. Damit kann eine durch das Entformen des Formkörpers gemäß Schritt c) 103 von der in Schritt b) 102 einprägten Form 11 des Formkörpers 12 abweichende Form 13 des Formkörpers 10 ganz oder zumindest teilweise wiederhergestellt werden.

In einer besonderen Ausgestaltung des vorliegenden Verfahrens 100 kann eine so genannte "Selbstheilung" einer im Anschluss an Schritt d) erfolgten weiteren Verformung der Form 11 des Formkörpers 10 vorgenommen werden. Zur Selbstheilung kann das Formgedächtnismaterial 31 erneut in den vierten Zustand 114 überführt werden, in welchem der Formkörper 10 dann selbsttätig die Form 11 ganz oder zumindest teilweise wieder annimmt. Auf diese Weise können absichtlich vorgenommene oder versehentlich aufgetretene Verformungen des Formkörpers 10 ganz oder zumindest teilweise wieder beseitigt werden.

Figur 2 zeigt eine zeitliche Veränderung von Prozessparametern während einer besonderen Ausführung des vorliegenden Verfahrens 100, insbesondere während einer Herstellung von freistehenden Linsen, welche über Strukturen mit Hinterschnitten 20 verfügten. Figur 2 zeigt einerseits den Verlauf der Temperatur T [°C] in dem Formwerkzeug 40 (rechts; gestrichelte Linie) sowie andererseits den Verlauf der auf das Material 30 in der Aufnahme des Formwerkzeugs 40 einwirkenden Kraft F [N] (links; durchgezogene Linie) über den zeitlichen Ablauf t [s] einer bevorzugten Ausführung des vorliegenden Verfahrens 100. Die oben zu Figur 1 erläuterten Schritte a) bis d) 101, 102, 103, 104 sind klar erkennbar und nur durch typische Heiz- bzw. Kühlperioden voneinander abgrenzbar.

Für das vorliegende Verfahren 100 wurde hierzu der bekannte Prozess des Heißprägens oder des thermischen Nano-Imprints verwendet. Hierfür wurden jeweils aufrecht stehende, bikonvexe optische Linsen mit Brennweiten von 50 µm, 100 µm und 150 µm hergestellt, die jeweils für eine Wellenlänge von 1550 nm eingerichtet waren. Das Material 30 umfasste das Formgedächtnispolymer Tecoflex^{®}, welches eine temporäre Übergangstemperatur Tₜᵣₐₙₛ ≈ 55 °C und eine permanente Verformungstemperatur Tₚₑᵣₘ ≈ 105 °C aufweist. Für das Formwerkzeug 40, welches über eine Fläche von (15 mm)² verfügte, wurden die Linsen mittels 2-Photonen-Lithografie hergestellt und anschließend galvanisch in das Formwerkzeug 40 kopiert. Nach erfolgreichem Aufwachsen des Metallformwerkzeugs 40 wurden sämtliche Polymerreste durch Plasmaätzen entfernt. Hierzu wurde ein Gasgemisch aus Sauerstoff und Chlor bei einer Temperatur von 60 °C und einer Leistung von 1200 W über eine Dauer von einer Stunde verwendet.

Insbesondere wurde das Formgedächtnismaterial 31 zunächst auf eine Temperatur zwischen der temporären Übergangstemperatur Tₜᵣₐₙₛ und der permanenten Verformungstemperatur Tₚₑᵣₘ gebracht, um so eine verbesserte Fließeigenschaft des Formgedächtnismaterials 31 zu erreichen. Wird Schritt b) 102 bei einer Temperatur oberhalb der permanenten Verformungstemperatur Tₚₑᵣₘ durchgeführt, weist das Formgedächtnismaterial 31 bereits eine zu geringe Viskosität auf, so dass das Formgedächtnismaterial 31 in Folge dessen bevorzugt senkrecht zur aufgebrachten Kraft, d.h. parallel zu einer Oberfläche des Formwerkzeugs 40 abfließen und nicht vollständig in die Aufnahme 12 oder Kavitäten des Formwerkzeugs 40 eindringen kann. Nach einer Haltezeit von 300 s bei einer Kraft von 5 kN auf die Fläche von (15 mm)² wird das Formgedächtnismaterial 31 auf eine Temperatur von 125 °C gebracht, also oberhalb der permanenten Verformungstemperatur Tₚₑᵣₘ. Dadurch übernimmt der Formkörper 10 die durch die Aufnahme 12 des Formwerkzeugs 40 vorgegebene Form als die Form 11 des Formgedächtnismaterials 31. Hieran anschließend wird die angelegte Kraft auf 1 kN herabgesetzt, um ein Abfließen des Formgedächtnismaterials 31 senkrecht zur Richtung angelegten Kraft zu verhindern. Durch die Kraft kann lediglich ein möglicher Schrumpf des Formgedächtnismaterials 31 verhindert und/oder kompensiert werden. Schließlich wurde nach einer Haltezeit von 120 s die Temperatur auf 75 °C gesenkt, so dass das Formgedächtnismaterial 31 nur noch temporär verformt werden konnte. Das Formwerkzeug 40 und eine der Aufnahme 12 gegenüber angeordnete Gegenplatte wurden mit einer Geschwindigkeit von 0,15 mm/min auseinander gefahren, wodurch der Formkörper 10 von dem Formwerkzeug 40 getrennt und somit entformt werden konnte. Der abschließende Rückstellschritt d) 104 erfolgte hier durch Erwärmen des Formkörpers 1) auf eine Temperatur oberhalb von 50 °C, jedoch unterhalb von 70° C, wahlweise in einem Ofen oder durch Anwendung eines Heißluftgebläses.

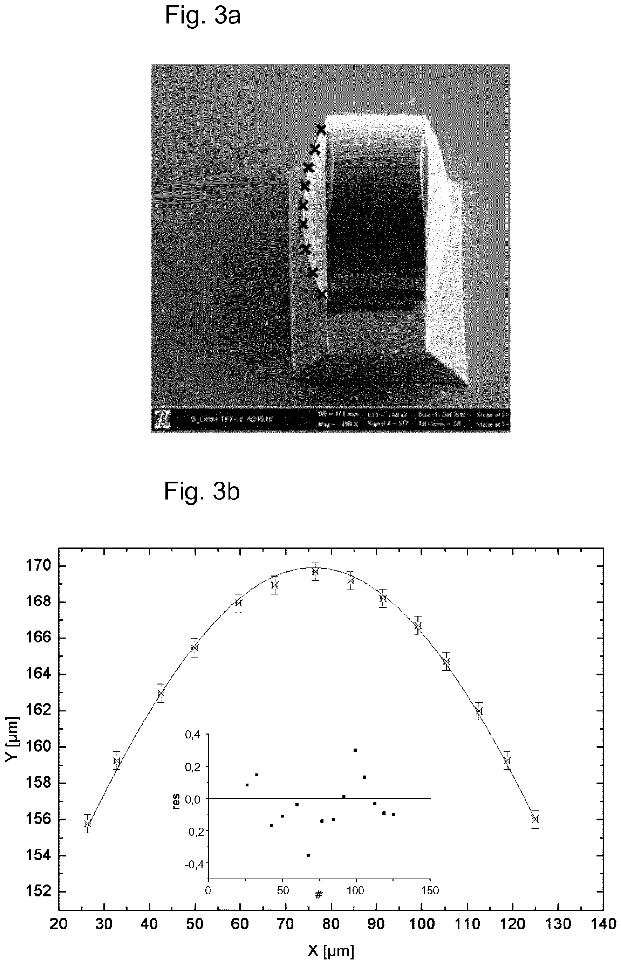

In Figur 3 zeigt eine Messung der Formtreue von Strukturen, welche mit dem vorliegenden Verfahren hergestellt wurden. Mehrere Positionen entlang eines Querschnitts des in Form einer optischen Linse hergestellten Formkörpers 10 gemäß der rasterelektronischen Aufnahme in Figur 3a wurden bestimmt und in ein Diagramm gemäß Figur 3b aufgetragen. Hierein ist die Ausdehnung des hergestellten Formkörpers 10 in Form von Werten für eine Y-Achse [µm] entlang der optischen Achse gegenüber Werten für eine X-Achse [µm] entlang eines Durchmessers quer zur optischen Achse aufgetragen. In dem Diagramm ist die vorgegebene Soll-Struktur als durchgezogene Linie dargestellt und deckt sich innerhalb eines Messfehlers mit den als Kreuz und Fehlerbalken versehenen Messungen. Angegeben sind jeweils die Messpunkte mit der in CAD gestalteten Form als Referenz. Es ergab sich ein Bestimmtheitsmaß von R² = (1 - 3,3 ·10⁻³) zwischen den gemessenen Punkten entlang der Linsenkontur und der vorgegebenen Kontur in der ursprünglichen CAD-Konstruktion. Die Differenzen, welche im Einsatz zu Figur 3b dargestellt sind, zeigen keine systematischen Abweichungen und bestätigen nochmals die Formtreue der mit dem vorliegenden Verfahren hergestellten optischen Linse. Neben einem Aspektverhältnis der optischen Linsen mit Werten von 6 bzw. 1,5 ergab sich ein Hinterschnitt-Verhältnis, welches als maximale Breite des Hinterschnitts 20 zu schmalsten Stelle der Struktur unterhalb des Hinterschnitts 20 definiert werden kann, mit Werten von 3 bzw. 1.5.

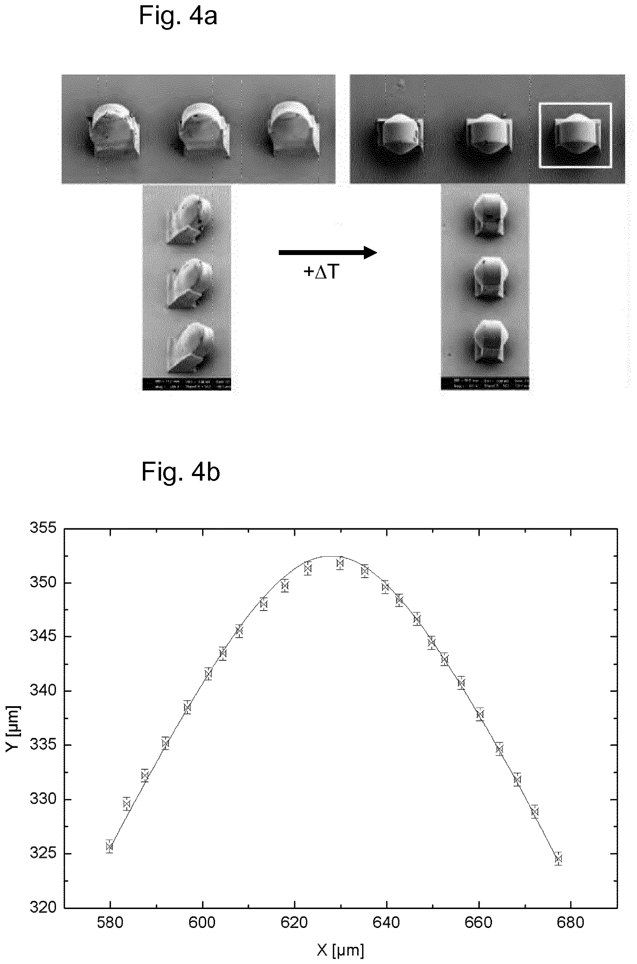

Auch die Selbstheilungseigenschaften der so hergestellten optischen Linsen konnten experimentell bestätigt werden. Figur 4 zeigt bespielhaft die Selbstheilungsfähigkeit von Strukturen in Form von optischen Linsen, welche mit dem vorliegenden Verfahren hergestellt wurden. Dazu wurden die optischen Linsen nach ihrer Herstellung gemäß dem vorliegenden Verfahren bei Raumtemperatur stark deformiert, sowohl umgekippt als auch geklemmt und verzogen. Die deformierten und verkippten Linsen in der linken Hälfte der Figur 4a stellen sich nach kurzem Erwärmen + ΔT wieder in ihre ursprüngliche Form 11 zurück, wie aus der rechten Hälfte der Figur 4a hervorgeht. Sowohl die Verkippung der gesamten optischen Linse als auch die verformte Linsenoberfläche konnten vollständig rückgängig gemacht werden, sodass sowohl die Form 11 als auch die Funktion der Strukturen wiederhergestellt werden konnte. Die Rückstellung erfolgte hierbei, indem die optischen Linsen in den vierten Zustand 114 entsprechend Schritt d) 104 gebracht wurden. Im Fall des Formgedächtnismaterials 31 Tecoflex^{®} entspricht das einer Erwärmung des Formkörpers 10 auf ca. 75° C für mindestens 30 s. Die Zeitdauer bis zu einer vollständigen Rückstellung hängt dabei insbesondere von der Geometrie des Formkörpers 10, dessen absoluter Größe sowie des Grades der Verformung ab.

Figur 4b zeigt eine Darstellung der messtechnischen Erfassung der Linsenoberfläche nach Wiederherstellung durch die Selbstheilungsfähigkeit. In Analogie zu Figur 3b ist auch hierin die Ausdehnung des hergestellten Formkörpers 10 in Form von Werten für eine Y-Achse [µm] entlang der optischen Achse gegenüber Werten für eine X-Achse [µm] entlang eines Durchmessers quer zur optischen Achse aufgetragen. Auch in dem Diagramm gemäß Figur 4b ist die vorgegebene Soll-Struktur als durchgezogene Linie dargestellt und deckt sich innerhalb eines Messfehlers im Wesentlichen mit den als Kreuz und Fehlerbalken versehenen Messungen.

### Bezugszeichenliste

- 10: Formkörper
- 11: Form
- 12: Aufnahme (Kavität)
- 13: Form in Folge eines Entformens
- 20: Hinterschnitt
- 30: Material
- 31: Formgedächtnismaterial
- 32: Mischung aus Materialien
- 33: Ausgangsmaterial
- 40: Formwerkzeug
- 41: Ausbreitungsrichtung und/oder Fließrichtung
- 43: Entformrichtung
- 44: Rückstellrichtung
- 100: Verfahren
- 101: Schritt a)
- 102: Schritt b)
- 103: Schritt c)
- 104: Schritt d)
- 110: stabiler Zustand
- 111: erster Zustand
- 112: zweiter Zustand
- 113: dritter Zustand
- 114: vierter Zustand

## Patentansprüche

1. Verfahren (100) zur Herstellung eines Formkörpers (10), umfassend ein mikro-optisches Bauteil, das eine Kavität und/oder auf einer Oberfläche des Formkörpers (10) hervorstehende Strukturen aufweist, wobei das Verfahren die folgenden Schritte umfasst:
a) Bereitstellen eines Formwerkzeugs (40), welches mit Hinterschnitten, die in dem Formkörper (10) zu Kavitäten und/oder auf der Oberfläche des Formkörpers (10) hervorstehende Strukturen führen, versehen ist, wobei das Formwerkzeug (40) mindestens eine Aufnahme (12) aufweist, in welche mindestens ein Material (30) eingebracht wird, wobei das Material (30) mindestens ein Formgedächtnismaterial (31) umfasst, wobei das Formgedächtnismaterial (31) in einem ersten Zustand (111) vorliegt, wobei das Material (30) die Aufnahme (12) des Formwerkzeugs (40) zumindest teilweise derart ausfüllt, dass es an mindestens eine Oberfläche der Aufnahme (12) angrenzt;
b) Erzeugen eines Formkörpers (10) in der Aufnahme (12) des Formwerkzeugs (40) aus dem Material (30), wobei das Formgedächtnismaterial (31) in einem zweiten Zustand (112) vorliegt, wobei während des zweiten Zustands (112) eine Form (11) in den Formkörper (10) eingeprägt wird;
c) Überführen des Formgedächtnismaterials (31) aus dem zweiten Zustand (112) in einen dritten Zustand (113), wobei der Formkörper (10) während des dritten Zustands (113) derart verformbar ist, dass ein Entformen des Formkörpers (10) aus der Aufnahme (12) des Formwerkzeugs (40) in Entformrichtung (43) erfolgt; und
d) Zumindest teilweises Wiederherstellen der Form (11) des Formkörpers (10) durch Überführen des Formgedächtnismaterials (31) aus dem dritten Zustand (113) in einen vierten Zustand (114), wobei der Formkörper (10) während des vierten Zustands (114) die Form (11) gemäß Schritt b) zumindest teilweise wieder annimmt.

2. Verfahren (100) nach dem vorangehenden Anspruch, wobei das Verfahren (100) einen Prozess des Heißprägens oder eines thermischen Nano-Imprints verwendet.

3. Verfahren nach einem der vorangehenden Ansprüche, wobei das während Schritt a) bereitgestellte Material (30) derart an die mindestens eine Oberfläche der Aufnahme (12) angrenzt, dass eine formtreue Abbildung einer durch die Aufnahme (12) festgelegten Negativform auf den herzustellenden Formkörper (10) erfolgt.

4. Verfahren nach einem der vorangehenden Ansprüche, wobei das während Schritt a) bereitgestellte Material (30) nicht-magnetische Partikel, ausgewählt aus Mikropartikeln oder Nanopartikeln, umfasst.

5. Verfahren nach dem vorangehenden Anspruch, wobei die Partikel Kohlenstoff, Siliziumdioxid und/oder ein Metall aufweisen.

6. Verfahren nach einem der beiden vorangehenden Ansprüche, wobei die Partikel optisch aktiv sind.

7. Verfahren nach einem der vorangehenden Ansprüche, wobei während Schritt a) und/oder von Schritt a) zu Schritt b) und/oder während Schritt b) ein Überführen des Formgedächtnismaterials (31) aus dem ersten Zustand (111) in den zweiten Zustand (112) erfolgt.

8. Verfahren nach dem vorangehenden Anspruch, wobei das Überführen des Formgedächtnismaterials (31) aus dem ersten Zustand (111) in den zweiten Zustand (112) durch Beaufschlagen des Formkörpers (10) mit einer gegenüber dem ersten Zustand (111) erhöhten Temperatur erfolgt.

9. Verfahren nach einem der vorangehenden Ansprüche, wobei das Überführen des Formgedächtnismaterials (31) aus dem zweiten Zustand (112) in einen dritten Zustand (113) während Schritt c) durch Beaufschlagen des Formkörpers (10) mit Licht, durch Beaufschlagen des Formkörpers (10) mit einer gegenüber dem zweiten Zustand (112) verringerten Temperatur oder durch Beaufschlagen des Formkörpers (10) mit einer gegenüber dem zweiten Zustand (112) verringerten Krafteinwirkung erfolgt.

10. Verfahren nach einem der vorangehenden Ansprüche, wobei das Überführen des Formgedächtnismaterials (31) in den vierten Zustand (114) während Schritt d) durch Beaufschlagen des Formkörpers (10) mit Licht, durch Beaufschlagen des Formkörpers (10) mit einer gegenüber dem dritten Zustand (113) geänderten Temperatur oder durch Belassen des Formkörpers (10) bei Normalbedingungen erfolgt.

11. Verfahren nach einem der vorangehenden Ansprüche, wobei der Formkörper (10) nach einer im Anschluss an Schritt d) erfolgten weiteren Verformung der Form (11) durch erneutes Überführen des Formgedächtnismaterials (31) in den vierten Zustand (114), in welchem es die Form (11) zumindest teilweise wieder annimmt.

12. Verfahren nach einem der vorangehenden Ansprüche, wobei das Formgedächtnismaterial (31) ausgewählt ist aus einem thermoplastischen Polyurethan.

13. Formkörper (10), umfassend ein mikrooptisches Bauteil, das eine Kavität und/oder auf der Oberfläche des Formkörpers (10) hervorstehende Strukturen aufweist, erhältlich nach einem Verfahren gemäß einem der vorangehenden Ansprüche.

14. Formkörper (10) nach dem vorangehenden Anspruch, wobei der Formköper (10) mindestens einen Hinterschnitt (20) aufweist.

15. Formkörper (10) nach einem der beiden vorangehenden Ansprüche, wobei der Formkörper (10) eine formtreue Abbildung einer durch die Aufnahme (12) des Formwerkzeugs (40) festgelegten Negativform auf den Formkörper (10) umfasst.

## Claims

1. A method (100) for producing a molded body (10) comprising a micro-optical component that has a cavity and/or protruding structures on a surface of the molded body (10), wherein the method comprises the following steps:
a) providing a molding tool (40) provided with undercuts which result in cavities in the molded body (10) and/or protruding structures on the surface of the molded body (10), wherein the molding tool (40) has at least one receptacle (12) into which at least one material (30) is introduced, wherein the material (30) comprises at least one shape-memory material (31), wherein the shape-memory material (31) is present in a first state (111), wherein the material (30) at least partially fills the receptacle (12) of the molding tool (40) in such a way that the material adjoins at least one surface of the receptacle (12);
b) creating a molded body (10) in the receptacle (12) of the molding tool (40) from the material (30), wherein the shape-memory material (31) is present in a second state (112), wherein a form (11) is embossed into the molded body (10) during the second state (112);
c) transferring the shape-memory material (31) from the second state (112) to a third state (113), wherein the molded body (10) can be deformed during the third state (113) in such a way that the molded body (10) is demolded from the receptacle (12) of the molding tool (40) in a demolding direction (43); and
d) at least partially restoring the form (11) of the molded body (10) by transferring the shape-memory material (31) from the third state (113) to a fourth state (114), wherein the molded body (10) at least partially resumes the form (11) according to step b) during the fourth state (114).

2. The method (100) according to the preceding claim, wherein the method (100) uses a hot stamping process or a thermal nano-imprinting process.

3. The method according to either of the preceding claims, wherein the material (30) provided during step a) adjoins the at least one surface of the receptacle (12) in such a way that a negative form defined by the receptacle (12) is dimensionally accurately reproduced on the molded body (10) that is to be produced.

4. The method according to one of the preceding claims, wherein the material (30) provided during step a) comprises non-magnetic particles which are selected from microparticles or nanoparticles.

5. The method according to the preceding claim, wherein the particles comprise carbon, silicon dioxide and/or a metal.

6. The method according to either of the two preceding claims, wherein the particles are optically active.

7. The method according to one of the preceding claims, wherein, during step a) and/or from step a) to step b) and/or during step b), the shape-memory material (31) is transferred from the first state (111) to the second state (112).

8. The method according to the preceding claim, wherein the shape-memory material (31) is transferred from the first state (111) to the second state (112) by subjecting the molded body (10) to an elevated temperature in comparison with the first state (111) .

9. The method according to one of the preceding claims, wherein the shape-memory material (31) is transferred from the second state (112) to a third state (113) during step c) by exposing the molded body (10) to light, by subjecting the molded body (10) to a reduced temperature in comparison with the second state (112) or by subjecting the molded body (10) to a reduced degree of action of force in comparison with the second state (112).

10. The method according to one of the preceding claims, wherein the shape-memory material (31) is transferred to the fourth state (114) during step d) by exposing the molded body (10) to light, by subjecting the molded body (10) to a changed temperature in comparison with the third state (113) or by leaving the molded body (10) in standard conditions.

11. The method according to one of the preceding claims, wherein the molded body (10), after a further deformation of the form (11) that took place following step d), by transferring the shape-memory material (31) to the fourth state (114) again, in which it at least partially resumes the form (11).

12. The method according to one of the preceding claims, wherein the shape-memory material (31) is selected from a thermoplastic polyurethane.

13. Molded body (10) which comprises a micro-optical component having a cavity and/or projecting structures on the surface of the molded body (10), obtainable by a method according to one of the preceding claims.

14. Molded body (10) according to the preceding claim, wherein the molded body (10) has at least one undercut (20).

15. Molded body (10) according to either of the two preceding claims, wherein the molded body (10) comprises a dimensionally accurate reproduction of a negative form, defined by the receptacle (12) of the molding tool (40), on the molded body (10).

## Revendications

1. Procédé (100) de production d'un corps moulé (10) comprenant un composant micro-optique qui comporte une cavité et/ou des structures faisant saillie sur une surface du corps moulé (10), le procédé comprenant les étapes suivantes :
a) fournir un moule (40) qui est pourvu de contre-dépouilles qui mènent à des cavités dans le corps moulé (10) et/ou à des structures faisant saillie sur la surface du corps moulé (10), le moule (40) comportant au moins un logement (12) dans lequel est introduit au moins un matériau (30), le matériau (30) comprenant au moins un matériau à mémoire de forme (31), le matériau à mémoire de forme (31) étant dans un premier état (111), le matériau (30) remplissant au moins partiellement le logement (12) du moule (40) de manière à être adjacent à au moins une surface du logement (12) ;
b) réaliser un corps moulé (10) dans le logement (12) du moule (40) à partir du matériau (30), le matériau à mémoire de forme (31) étant dans un deuxième état (112), une forme (11) étant imprimée dans le corps moulé (10) pendant le deuxième état (112) ;
c) transférer le matériau à mémoire de forme (31) du deuxième état (112) à un troisième état (113), le corps moulé étant déformable pendant le troisième état (113) de manière à ce que le corps moulé (10) soit retiré du logement (12) du moule (40) dans la direction de démoulage (43) ; et
d) restaurer au moins partiellement la forme (11) du corps moulé (10) par transfert du matériau à mémoire de forme (31) du troisième état (113) à un quatrième état (114), le corps moulé (10) reprenant au moins partiellement la forme (11) selon l'étape b) pendant le quatrième état (114).

2. Procédé (100) selon la revendication précédente, le procédé (100) utilisant un processus de marquage à chaud ou de nano-impression thermique.

3. Procédé selon l'une des revendications précédentes, le matériau (30) fourni à l'étape a) étant adjacent à l'au moins une surface du logement (12) de manière à effectuer une reproduction fidèle d'une forme négative, définie par le logement (12), sur le corps moulé (10).

4. Procédé selon l'une des revendications précédentes, le matériau (30) fourni à l'étape a) comprenant des particules non magnétiques sélectionnées parmi les microparticules ou les nanoparticules.

5. Procédé selon la revendication précédente, les particules comprenant du carbone, du dioxyde de silicium et/ou un métal.

6. Procédé selon l'une des deux revendications précédentes, les particules étant optiquement actives.

7. Procédé selon l'une des revendications précédentes, le matériau à mémoire de forme (31) étant transféré du premier état (111) au deuxième état (112) à l'étape a) et/ou de l'étape a) à l'étape b) et/ou à l'étape b).

8. Procédé selon la revendication précédente, le matériau à mémoire de forme (31) étant transféré du premier état (111) au deuxième état (112) par soumission du corps moulé (10) à une température qui est augmentée par rapport au premier état (111).

9. Procédé selon l'une des revendications précédentes, le transfert du matériau à mémoire de forme (31) du deuxième état (112) à un troisième état (113) à l'étape c) est effectué par application de lumière au corps moulé (10), par application de lumière au corps moulé (10) avec une température réduite par rapport au deuxième état (112) ou par application d'une force, réduite par rapport au deuxième état (112), au corps moulé (10).

10. Procédé selon l'une des revendications précédentes, le transfert du matériau à mémoire de forme (31) dans le quatrième état (114) à l'étape d) étant effectué par application de lumière au corps moulé (10), par application au corps moulé (10) d'une température modifiée par rapport au troisième état (113) ou par maintien du corps moulé (10) dans des conditions normales.

11. Procédé selon l'une des revendications précédentes, après une autre déformation de la forme (11) effectuée après l'étape d), le corps moulé (10) par un nouveau transfert du matériau à mémoire de forme (31) dans le quatrième état (114) dans lequel il prend au moins partiellement à nouveau la forme (11).

12. Procédé selon l'une des revendications précédentes, le matériau à mémoire de forme (31) étant choisi parmi un polyuréthane thermoplastique.

13. Corps moulé (10), comprenant un composant micro-optique qui comporte une cavité et/ou des structures faisant saillie sur la surface du corps moulé (10), ledit corps moulé pouvant être obtenu par un procédé selon l'une des revendications précédentes.

14. Corps moulé (10) selon la revendication précédente, le corps moulé (10) comportant au moins une contre-dépouille (20).

15. Corps moulé (10) selon l'une des deux revendications précédentes, le corps moulé (10) comprenant une reproduction fidèle d'une forme négative, définie par le logement (12) du moule (40), sur le corps moulé (10).
